# EUROPÄISCHE PATENTSCHRIFT

(11) **EP 1 000 366 B1**
(45) Veröffentlichungstag und Bekanntmachung des Hinweises auf die Patenterteilung: **16.10.2002**
(21) Anmeldenummer: 98949870.4
(22) Anmeldetag: 30.07.1998
(51) Int. Cl.: G01R 31/327

(54) **VORRICHTUNG ZUR MESSUNG VON TEILENTLADUNGEN IN GASISOLIERTEN HOCHSPANNUNGSANLAGEN**
DEVICE FOR MEASURING PARTIAL DISCHARGES IN GAS-INSULATED HIGH VOLTAGE FACILITIES
DISPOSITIF POUR MESURER DES DECHARGES PARTIELLES DANS DES INSTALLATIONS HAUTE TENSION ISOLEES AU GAZ

(30) Priorität: 31.07.1997 DE 19734552
(43) Veröffentlichungstag der Anmeldung: 17.05.2000
(73) Patentinhaber: SIEMENS AKTIENGESELLSCHAFT, 80333 München (DE)
(72) Erfinder: HÜCKER, Thomas, 14624 Dallgow-Döberitz (DE)
(86) Internationale Anmeldenummer: DE9802290
(87) Internationale Veröffentlichungsnummer: WO99006847

(56) Entgegenhaltungen:
- EP-A- 0 488 719
- EP-A- 0 699 918
- EP-A- 0 780 692

## Beschreibung

Die Erfindung bezieht sich auf eine Vorrichtung zur Messung von Teilentladungen in gasisolierten Hochspannungsanlagen mit einem ersten kalibrierbaren, zur Messung im HF-Bereich geeigneten Sensor und einem zweiten,zum Nachweis von für Teilentladungen charakteristischen Signalanteilen im UHF-Bereich geeigneten Sensor, die innerhalb einer Metallkapselung angeordnet sind, mit einem ersten Zweig zur Verarbeitung eines HF-Signalanteils und einem zweiten Zweig zur Verarbeitung eines UHF-Signalanteils, sowie mit einer mit dem ersten und dem zweiten Sensor verbundenen Toreinrichtung.

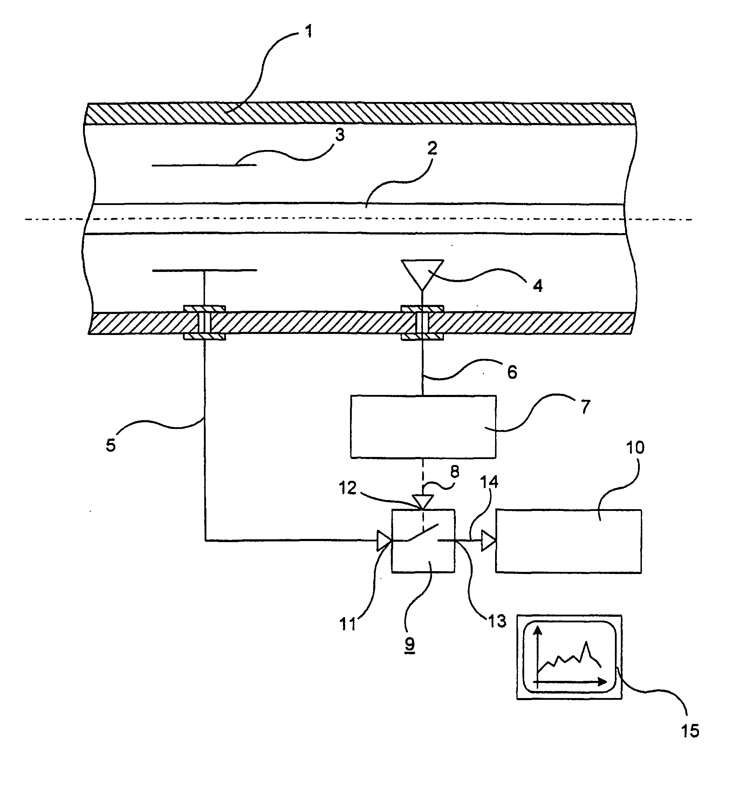

Aus der EP 0 488 719 A2 ist eine Vorrichtung und ein Verfahren zur Detektion von Teilentladungen in gasisolierten Schaltanlagen bekannt (vgl. dort Figur 6). Dort wird über einen ersten kapazitiven Sensor eine Nutzfrequenz und eine gegebenenfalls durch Störungen erzeugte HF-Komponente unterhalb von einigen hundert kHz aufgenommen. Mittels Filtereinrichtungen können diese Signalanteile getrennt werden. Über zwei verschiedene Signalverarbeitungszweige werden die gewonnenen Signale in eine zur weiteren Verarbeitung geeignete Form umgesetzt und einer Recheneinrichtung zugeführt. Das im Hochfrequenzbereich unterhalb von einigen hundert kHz gewonnene Signal dient zur Identifizierung von externen Störungen. Der Nulldurchgang der Hochspannung dient als Triggersignal für den Beginn der Teilentladungsmessung. Mittels eines zweiten Sensors werden Teilentladungssignale im Bereich einiger 10 MHz aufgenommen und in einem entsprechenden Signalverarbeitungszweig zur Identifikation der Teilentladungen weiterverarbeitet. Durch die offenbarte Beschaltung wird dieser Sensor im Antennenbetrieb bei einigen 10 MHz betrieben und ist somit für Teilentladungsmessungen nicht kalibrierbar.

Unter dem HF-Bereich soll in diesem Zusammenhang der Frequenzbereich zwischen einigen 10 kHz und 100 MHz, unter dem UHF-Bereich der Frequenzbereich oberhalb von 100 MHz verstanden werden.

Aus der DE 195 48 466 A1 ist eine Vorrichtung der eingangs genannten Art bekannt. Dort wird das Tor bei Vorliegen eines Meßsignals von einem Sensor gesperrt, wobei das Eingangssignal zur Steuerung des Tors beispielsweise ein HF-Signal unterhalb von 10 MHz ist. Das von dem Tor zur weiteren Verarbeitung gegebenenfalls durchgelassene Signal ist beispielsweise ein breitbandiges UHF-signal im Bereich bis 1,5 GHz. Hierdurch sollen Störungen bei der Teilentladungsmessung vermieden werden. Bei diesem System ist jedoch keine kalibrierte Messung vorgesehen.

Der vorliegenden Erfindung liegt die Aufgabe zugrunde, die Zuverlässigkeit der Messung von Teilentladugen zu verbessern und gleichzeitig eine kalibrierte Messung zu ermöglichen.

Die Aufgabe wird erfindungsgemäß dadurch gelöst, daß die Toreinrichtung bei Vorliegen eines für eine Teilentladung charakteristischen UHF-Signalanteils betätigt wird und bei Betätigung den HF-Signalanteil zur Weiterverarbeitung durchläßt.

Durch den Einsatz eines ersten, kalibrierbaren Sensors kann ein sehr genaues und reproduzierbares Meßergebnis bei einer Teilentladungsmessung erzielt werden. Ein solcher Sensor kann beispielsweise eine Meßelektrode zur kapazitiven Ankopplung an einen in der Hochspannungsanlage angeordneten Hochspannungsleiter aufweisen. Der zweite, für den UHF-Bereich geeignete und beschaltete Sensor ist durch seine äußere Beschaltung nicht kalibrierbar, jedoch dient er als Detektor für Teilentladungen im Zusammenwirken mit dem ersten Sensor. Der zweite Sensor liefert lediglich eine Information über das Vorliegen oder Nichtvorliegen einer Teilentladung und betätigt die Toreinrichtung in entsprechender Weise. Eine Kalibrierung des zweiten Sensors ist nicht notwendig. Ein solcher UHF-Sensor kann beispielsweise eine Antenne zur Detektion elektromagnetischer Strahlung aufweisen oder auch ein Gerät, das einen für Teilentladungen typischen Signalanteil auf andere Weise, beispielsweise chemisch, optisch oder akkustisch nachweist. Durch den Einsatz von zwei Sensoren, einem ersten Sensor, der im HF-Bereich wirksam ist und einem zweiten Sensor, der im UHF-Bereich wirksam ist und die Ausführung von zwei Zweigen, wird bereits auf Sensorebene die notwendige Signalverarbeitung für das zuverlässige Messen von Teilentladungen verwirklicht. Die Toreinrichtung eignet sich, um das Zusammenwirken des UHF-Signalanteils und des HF-Signalanteils zu steuern. Über einen zweiten Eingang (Steuereingang) kann durch den UHF-Signalanteil die Öffnung der Toreinrichtung für eine gewisse Zeit veranlaßt oder ggf. die Öffnungsdauer der Toreinrichtung bestimmt werden, während der über einen zweiten Eingang der HF-Signalanteil zur weiteren Verarbeitung übertragen wird.

Bei Einstrahlung einer externen Störung, die nicht auf eine Teilentladung zurückzuführen ist, gelangt ein gegebenenfalls vorliegender UHF-Signalanteil nur stark gedämpft in die Hochspannungsanlage, so daß die Toreinrichtung in diesem Fall nicht betätigt wird. Die Toreinrichtung wird erst bei Überschreiten eines bestimmten Signalschwellwertes geöffnet.

Bei einer vorteilhaften Ausgestaltung der Erfindung kann vorgesehen sein, daß der erste und der zweite Sensor unmittelbar benachbart sind.

Hierdurch nehmen beide Sensoren räumlich wie auch zeitlich betrachtet dasselbe Signal auf, ohne daß unterschiedliche Verfälschungen des Signals auftreten können.

Bei einer weiteren vorteilhaften Ausgestaltung der Erfindung kann vorgesehen sein, daß als UHF-Sensor eine Kegelantenne vorgesehen ist.

Kegelantennen eignen sich aufgrund ihrer Bauform besonders gut zur Messung von UHF-Signalen.

Zur Messung HF-Signalen eignen sich beispielsweise Zylinderelektroden, die den Hochspannungsleiter konzentrisch umgeben.

Vorteilhaft kann auch vorgesehen sein, daß dererste und der zweite Sensor zu einem einzigen Breitbandsensor, der als Empfänger sowohl für UHF- als auch für HF-Signale dient zusammengefaßt sind, der durch Beschaltung mit zwei Signal verarbeidungszweigen gleichzeitig sowohl im HF-Bereich als auch im UHF-Bereich betreibbar ist. Durch den Einsatz von nur einem Breitbandsensor können weitere Sensoren entfallen. Dieser Sensor muß dann durch entsprechende Beschaltung mit zwei Signalverarbeitungszweigen gleichzeitig sowohl im HF-Bereich (kapazitiver Betrieb) als auch im UHF-Bereich (Antennenbetrieb) betreibbar sein.

In einem Verfahren zur Messung von Teilentladungen in gasisolierten Schaltanlagen ist vorgesehen, daß innerhalb einer Kapselung ein UHF-Signalanteil und ein HF-Signalanteil aufgenommen werden und bei Vorliegen eines UHF-Signalanteils, der eine bestimmte Schwelle überschreitet, ein Torelement betätigt wird, um den HF-Signalanteil zur Weiterverarbeitung zu übertragen.

Durch die getrennte Erfassung eines UHF-Signalanteils und eines HF-Signalanteils wird eine frequenzbandbezogene Signaltrennung direkt nach der Signalaufnahme erreicht. Der gewonnene UHF-Signalanteil dient als Steuersignal für die Öffnung der Toreinrichtung, durch die das HF-Signal durchgelassen wird.

Es ist auch denkbar, die vorliegende Erfindung mittels eines programmierbaren, mit analogen Eingängen ausgestatteten Rechners durchzuführen. Die von den Sensoren aufgenommenen UHFund HF-Signalanteile gelangen über die analogen Eingänge in den Rechner. Ein Rechnerprogramm bearbeitet und bewertet die Signalanteile und visualisiert das Ergebnis auf einer Anzeige oder einem Bildschirm.

Anhand der Zeichnung ist im folgenden ein Ausführungsbeispiel der Erfindung beschrieben und die Wirkungsweise erläutert.

In der Figur ist schematisch ein Längsschnitt durch einen ausgewählten Bereich einer gasisolierten Schaltanlage mit einer erfindungsgemäßen Vorrichtung gezeigt.

Die gasisolierte Schaltanlage ist von einer gasdichten, metallischen, geerdeten, zylindrischen Kapselung 1 umgeben, die mit Isoliergas (vorwiegend wird SF₆ -Gas verwendet) gefüllt ist. Im Inneren der Kapselung 1 ist ein Leiter 2 axial angeordnet, der in regelmäßigen Abständen mittels Stützisolatoren in seiner Position gehalten wird. Um den Leiter 2 herum ist berührungsfrei ein kalibrierbarer HF-Sensor 3 in Form eines metallischen Hohlzylinders angeordnet. In der Kapselung 1 ist außerdem ein UHF-Sensor 4 isoliert angeordnet, der den UHF-Signalanteil einer Teilentladung aufnimmt und mittels eines Meßzweiges 6 diesen einer UHF-Impulserkennungseinheit 7 zuführt. Vom kalibrierbaren HF-Sensor 3 führt ein Meßzweig 5 zu einem ersten Eingang 11 einer Toreinrichtung 9. Von der UHF-Impulserkennungseinheit 7 führt ein Zweig 8 zu einem zweiten Eingang 12 derselben Toreinrichtung 9. Der zweite Eingang 12 der Toreinrichtung 9 stellt den Steuereingang 12 dar, d.h. hierüber wird die Dauer der Toröffnung bestimmt. Der erste Eingang 11 stellt den Signaleingang 11 dar. Bei Betätigen des Steuereingangs 12 kann ein Signal vom Signaleingang 11 an den Ausgang 13 der Toreinrichtung 9 übertragen werden. Vom Ausgang 13 der Toreinrichtung 9 führt eine Verbindung 14 zu einer Teilentladungsauswerteeinrichtung 10. Mittels eines Bildschirmes 15 kann das Teilentladungssignal graphisch dargestellt werden.

Bei Vorliegen einer Teilentladung treten Signale mit Frequenzanteilen unter anderem im UHF-Bereich auf. Bei Störungen innerhalb und außerhalb der Kapselung, die nicht auf Teilentladungen zurückzuführen sind, entstehen keine oder nur sehr geringe Frequenzanteile, die im UHF-Bereich innerhalb der GIS vorliegen. Dies wird in der vorliegenden Erfindung genutzt, um bei der Messung von Teilentladungen zu verhindern, daß durch den HF-Sensor fälschlicherweise Störsignale mitgemessen werden, die nicht aus Teilentladungen resultieren. Solche Signale werden durch die Toreinrichtung 3 gesperrt.

Tritt nun eine wirkliche Teilentladung auf, so nimmt der UHF-Sensor 4 den UHF-Signalanteil auf und leitet ihn zur UHF-Auswerteeinheit 7 weiter, in der das Vorliegen einer Teilentladung registriert wird. Da es sich um eine Teilentladung handelt, wird ein Signal erzeugt, das an den Steuereingang 12 der Toreinrichtung 9 gelangt und diesen für eine definierte Zeitspanne betätigt. Durch die Erfindung werden Signale, die nicht auf eine Teilentladung innerhalb der Hochspannungsanlage zurückzuführen sind, ausgeblendet. Liegt eine Teilentladung vor, so wird ein Teilentladungssignal von dem HF-Sensor 3 aufgenommen und gelangt über die Meßleitung 5 an den Signaleingang 11 der Toreinrichtung 9. Während der Steuereingang 12 betätigt wird, kann das Teilentladungssignal des Sensors 3 an den Ausgang 13 übertragen werden, von wo es zu der Teilentladungsauswerteeinrichtung 10 gelangt und ausgewertet werden kann.

## Patentansprüche

1. Vorrichtung zur Messung von Teilentladungen in gasisolierten Hochspannungsanlagen mit einem ersten kalibrierbaren, zur Messung im HF-Bereich geeigneten Sensor (3) und einem zweiten, zum Nachweis von für Teilentladungen charakteristischen Signalanteilen im UHF-Bereich geeigneten Sensor (4), die innerhalb einer Metallkapselung (1) angeordnet sind, mit einem ersten Zweig zur Verarbeitung eines HF-Signalanteils und einem zweiten Zweig zur Verarbeitung eines UHF-Signalanteils, sowie mit einer mit dem ersten und dem zweiten Sensor (3, 4) verbundenen Toreinrichtung (9),
**dadurch gekennzeichnet , daß**
die Toreinrichtung (9) bei Vorliegen eines für eine Teilentladung charakteristischen UHF-Signalanteils betätigt wird und bei Betätigung den HF-Signalanteil zur Weiterverarbeitung durchläßt.

2. Vorrichtung zur Messung von Teilentladungen in gasisolierten Schaltanlagen nach Anspruch 1
**dadurch gekennzeichnet, daß**
der erste und der zweite Sensor (3,4) unmittelbar benachbart sind.

3. Vorrichtung zur Messung von Teilentladungen in gasisolierten Schaltanlagen nach Anspruch 1 oder 2
**dadurch gekennzeichnet, daß**
als UHF-Sensor (3,4) eine Kegelantenne (4) vorgesehen ist.

4. Vorrichtung zur Messung von Teilentladungen in gasisolierten Schaltanlagen nach Anspruch 1 oder einem der folgenden
**dadurch gekennzeichnet, daß** der erste und der zweite Sensor zu einem einzigen Breitbandsensor, der als Empfänger sowohl für UHF- als auch für HF-Signale diente, zusammengefaßt sind, der durch Beschaltung mit zwei Signalverarbeidungszweigen gleichzeitig sowohl im HF - Bereich als auch im UHF - Bereich betreibbar ist.

5. Verfahren zur kalibrierbaren Messung von Teilentladungen in gasisolierten Schaltanlagen
**dadurch gekennzeichnet, daß**
innerhalb einer Kapselung (1) ein UHF-Signalanteil und ein HF-Signalanteil aufgenommen werden und bei Vorliegen eines UHF-Signalanteils, der eine fur Teilentladungen charakteristische Schwelle überschreitet, ein Torelement (9) betätigt wird, um den HF-Signalanteil zur Weiterverarbeitung zu übertragen.

## Claims

1. Device for measuring partial discharges in gas-insulated high voltage facilities with a first calibratable sensor (3) suitable for measuring in the HF range and a second sensor (4) suitable for the detection of signal components characteristic of partial discharges in the UHF range, the sensors being arranged inside a metal enclosure (1), with a first branch for processing an HF signal component and a second branch for processing a UHF signal component, and with a gate device (9) connected to the first and second sensor (3, 4), **characterized in that** the gate device (9) is activated when a UHF signal component characteristic of a partial discharge is present and when activated lets the HF signal component through for further processing.

2. Device for measuring partial discharges in gas-insulated switching facilities according to claim 1, **characterized in that** the first and second sensor (3, 4) are directly adjacent.

3. Device for measuring partial discharges in gas-insulated switching facilities according to claim 1 or 2, **characterized in that** a cone aerial (4) is provided as a UHF sensor (3, 4).

4. Device for measuring partial discharges in gas-insulated switching facilities according to claim 1 or one of the following claims, **characterized in that** the first and the second sensor are combined to form a single broadband sensor, which is used as a receiver both for UHF and HF signals and can be operated simultaneously both in the HF range and in the UHF range due to wiring to two signal processing branches.

5. Method for the calibratable measurement of partial discharges in gas-insulated switching facilities, **characterized in that** a UHF signal component and an HF signal component are registered inside an enclosure (1), and if a UHF signal component is present that exceeds a characteristic threshold for partial discharges, a gate element (9) is activated to transmit the HF signal component for further processing.

## Revendications

1. Dispositif de mesure de décharges partielles dans des installations en haute tension isolées par du gaz, comprenant un premier capteur (3) qui peut être étalonné et qui est approprié à la mesure dans le domaine HF et un deuxième capteur (4) de détection de composantes de signal caractérisant des décharges partielles et approprié au domaine UHF, qui sont disposés à l'intérieur d'un blindage (1) métallique, comprenant une première branche de traitement d'une composante de signal HF et une deuxième branche de traitement d'une composante de signal UHF ainsi que,
un dispositif (9) à porte relié au premier et au deuxième capteurs (3, 4),
**caractérisé en ce que** le dispositif (9) à porte est actionné en présence d'une composante de signal UHF caractérisant une décharge partielle et, lors de l'actionnement, laisse passer la composante de signal HF en vue du traitement ultérieur.

2. Dispositif de mesure de décharges partielles dans des installations de distribution isolées au gaz suivant la revendication 1, **caractérisé en ce que** le premier et le deuxième capteurs (3, 4) sont immédiatement voisins.

3. Dispositif de mesure de décharges partielles dans des installations de distribution isolées au gaz suivant la revendication 1 ou 2, **caractérisé en ce qu'**il est prévu comme capteur (3, 4) UHF, une antenne (4) conique.

4. Dispositif de mesure de décharges partielles dans des installations de distribution isolées au gaz suivant la revendication 1 ou l'une des suivantes, **caractérisé en ce que** le premier et le deuxième capteurs sont réunis en un capteur unique à bande large, qui sert de récepteur à la fois pour les signaux UHF et pour les signaux HF et qui peut fonctionner, par connexion à deux branches de traitement du signal, tant dans le domaine HF que dans le domaine VHF.

5. Procédé de mesure d'une manière qui peut être étalonnée de décharges partielles dans des installations de distribution isolées par du gaz,
**caractérisé en ce qu'**il consiste à recevoir dans un blindage (1) une composante de signal UHF et une composante de signal UHF et en présence d'une composante de signal UHF qui dépasse un seuil caractéristique de décharge partielle, à actionner un élément (9) de porte pour transmettre la composante de signal HF en vue de la traiter ultérieurement.
